# EUROPÄISCHE PATENTANMELDUNG

(11) **EP 1 253 812 A2**
(43) Veröffentlichungstag der Anmeldung: **30.10.2002**
(21) Anmeldenummer: 01123840.9
(22) Anmeldetag: 05.10.2001
(51) Int. Cl.: H05K 3/10

(54) **Verfahren und Anordnung zum Herstellen von elektrischen Leiterbahnen auf einem isolierenden Träger**

(30) Priorität: 10.10.2000 DE 10050167
(71) Anmelder: Lenhart, Armin, Prof. Dr., 91077 Neunkirchen a. Brand (DE); Pösl, Rudolf, Dipl.-Ing., 90543 Nürnberg (DE)
(72) Erfinder: Lenhart, Armin, Prof. Dr., 91077 Neunkirchen a. Brand (DE)
(74) Vertreter: Christ, Dieter, Dipl.-Ing.

(57) **Zusammenfassung**

Zun Herstellen von Leiterbahnen (3) wird eine Schicht (2) von metallischem Wolfram oder Molybdän auf den Träger (1) aufgebracht und durch die Energie eines Infrarotlasers die gewünschte Bahn (3) hergestellt.

## Beschreibung

Die Erfindung betrifft ein Verfahren und eine Anordnung zum Herstellen von elektrischen Leiterbahnen auf einem isolierenden Träger.
Zum Herstellen von elektrischen Leiterbahnen werden Leiterpasten mit Glasfluß und Metallpartikeln aufgebracht und nach einem Siebdruckverfahren eingebrannt. Mit Sonderverfahren können auch metallische Wolframschichten in reduzierender Atmosphäre eingebrannt werden. Auch hier ist die minimale Breite der Leiterbahnen durch das Siebdruckverfahren begrenzt.

Die Aufgabe der vorliegenden Erfindung besteht darin, ein Verfahren und eine Anordnung anzugeben, mit denen schnell und einfach relativ schmale elektrische Leiterbahnen auf dem Träger in wählbarer Konfiguration herstellbar sind.
Diese Aufgabe wird erfindungsgemäß dadurch gelöst, daß in einer auf dem Träger aufgebrachten Schicht aus metallischem Molybdänpulver durch die Energie eines Infrarotlasers mit einer Leistung zwischen 2-40 Watt und einer Vorschubgeschwindigkeit des Laserstrahles zwischen 10- 500 mm/sec die gewünschten Leiterbahnen durch Lasern hergestell werden.
Die Anordnung hierzu umfasst vorteilhafterweie einen positionierbaren Laser ,der von einem entsprechend der gewünschten Leiterbahnkonfiguration programmierten Rechner gesteuert wird..
Bei z.B. 8 Watt Leistung und 70mm/sec Vorschubgeschwindigkeit lassen sich so Leiterbahnen mit 30µ Breite -entsprechender Laserfokus vorausgesetzt-erzeugen, deren elektrische Leitfähigkeit besser als 0.7 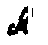 mm²/m ist.Die Schichtdicke betrug dabei 3µ.
Anhand einer Zeichnung sei die Anordnung schematisch erläutert:
Auf einem isolierenden Träger 1 aus Glas oder Keramik sollen elektrische Leiterbahnen 3 hergestellt werden.Auf dem Träger 1 ist eine dünne Schicht 2 (z.B. zwischen 3-10 µ) Wolframpulver aufgebracht.Durch den in x,y- Richtung steurbaren Strahl 6 des Infrarotlasers 4 werden die gewünschten Leiterbahnen 3 aufgebrannt. Die Breite der Leiterbahn lässt sich durch den Fokusort des Lasers verändem.Durch den Rechner5 lassen sich die Konfigurationen leicht ändern.

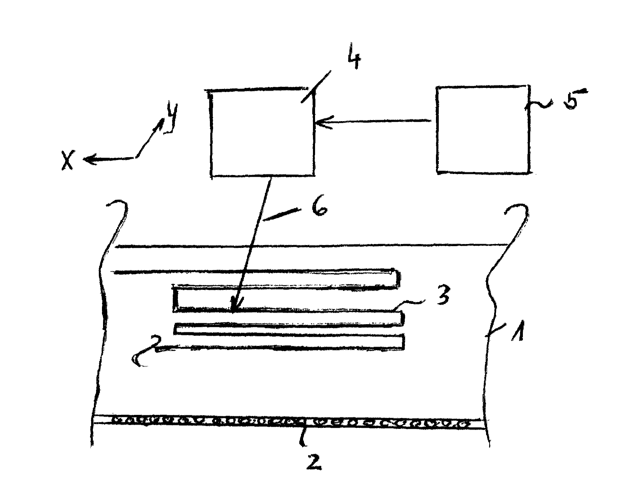

## Patentansprüche

1. Verfahren zum Herstellen von elektrischen Leiterbahnen auf einem isolierendem Träger,**dadurch gekennzeichnet, daß** in einer auf dem Träger aufgebrachten Schicht(2) aus metallischem Molybdän- und/oder Wolframpulver durch die Energie eines Infrarotlasers (4) mit einer Leistung zwischen 2-40 Watt und einer Vorschubgeschwindigkeit des Laserstrahles (6) zwischen 10-50 mm/sec die gewünschten Leiterbahnen durch Lasern hergestellt werden.

2. Verfahren nach Anspruch 1, **dadurch gekennzeichnet, daß** die Leistung des Lasers (4) zwischen 7-20 Watt und die Vorschubgeschwindigkeit zwischen 40-200 mm/sec gewählt wird.

3. Verfahren nach Anpruch 1, **dadurch gekennzeichnet, daß** das in einer Mischung aus organischen Substanzen gelöste Pulver auf dem Träger (1) aufgespritzt wird.

4. Verfahren nach Anspruch 1, bei dem mit einer Breite der Leiterbahnen zwischen 20-40 µ bei einer Schichtdicke zwischen 4-10 µ gearbeitet wird.

5. Anordnung zur Durchrührung des Verfahrens nach Anspruch 1,
**dadurch gekennzeichnet, daß** der steuerbare Infrarotlaser (4) relativ zum Träger (1) durch einen Rechner(5) positionierbar ist, der entsprechend der gewünschten Leiterbahnkonfiguratiom programmiert ist.
